(19) **Europäisches Patentamt**

**European Patent Office**

**Office européen des brevets**

(11) **EP 0 931 331 B1**

(12) **EUROPÄISCHE PATENTSCHRIFT**

(45) Veröffentlichungstag und Bekanntmachung des Hinweises auf die Patenterteilung:
**05.06.2002 Patentblatt 2002/23**

(21) Anmeldenummer: **97910352.0**

(22) Anmeldetag: **24.09.1997**

(51) Int Cl.[7]: **H01L 21/20**

(86) Internationale Anmeldenummer:
**PCT/EP97/05253**

(87) Internationale Veröffentlichungsnummer:
**WO 98/13860 (02.04.1998 Gazette 1998/13)**

(54) **VERFAHREN ZUM DAUERHAFTEN VERBINDEN VON SILIZIUMSCHEIBEN**

PROCESS FOR JOINING SILICON WAFERS IN PERMANENT MANNER

PROCEDE POUR ASSEMBLER DE FA ON DURABLE DES SUBSTRATS DE SILICIUM

(84) Benannte Vertragsstaaten:
**BE DE FR NL**

(30) Priorität: **26.09.1996 DE 19639682**

(43) Veröffentlichungstag der Anmeldung:
**28.07.1999 Patentblatt 1999/30**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **KLUMPP, Armin**
 **D-80337 München (DE)**
• **LANDESBERGER, Christof**
 **D-81241 München (DE)**

(74) Vertreter: **Schoppe, Fritz, Dipl.-Ing.**
**Schoppe, Zimmermann & Stöckeler**
**Patentanwälte**
**Postfach 71 08 67**
**81458 München (DE)**

(56) Entgegenhaltungen:
**DE-A- 4 404 931**

• **DEN BESTEN C ET AL: "POLYMER BONDING OF MICRO-MACHINED SILICON STRUCTURES" PROCEEDINGS OF THE WORKSHOP ON MICRO ELECTRO MECHANICAL SYSTEMS, TRAVEMUNDE, FEB. 4 - 7, 1992, Nr. WORKSHOP 5, 4.Februar 1992, BENECKE W;PETZOLD H -C, Seiten 104-109, XP000344134**

## Beschreibung

Die vorliegende Erfindung bezieht sich auf ein Verfahren zum dauerhaften Verbinden von anorganischen Substraten und insbesondere auf ein Verfahren zum Verbinden einer ersten und einer zweiten Siliziumscheibe mittels einer Polyimidschicht.

Auf dem Gebiet der Mikroelektronik erfordern zukünftige Anwendungen nicht nur eine Steigerung der Rechenleistung oder der Speicherkapazität eines IC-Bausteins (IC = integrated circuit = Integrierte Schaltung), sondern ferner auch eine Erweiterung der Funktionalität desselben. Eine derartige Funktionalitätserweiterung beinhaltet beispielsweise die Möglichkeit, Sensorik, Datenverarbeitung und Datenspeicherung auf einem Chipbaustein zu vereinigen, beispielsweise für einen CCD-Chip (CCD = charge coupled device = ladungsgekoppeltes Bauelement), der für die Auswertung und Reduktion von großen Datenmengen direkt auf einer Logikebene integriert ist. Ausgehend von der planaren Standard-CMOS-Technologie werden deshalb verstärkt Anstrengungen unternommen, die die Entwicklung einer vertikalen Verbindungstechnik betreffen, um den zukünftigen Systemanforderungen der Mikroelektronik gerecht zu werden.

Die gewünschte Option, auch Wafer mit sensitiven Oberflächenstrukturen mit einem zweiten Wafer vertikal zu integrieren, macht es notwendig, eine Verbindungstechnik zu besitzen, die das Aufeinandersetzen, d.h. das dauerhafte Verbinden, einer Waferrückseite und einer Waferoberseite ermöglicht. Es ist in der Technik bekannt, Oberflächen von Körpern, die aus Plasmaoxid, thermischem Oxid und Silizium bestehen, mit Polyimid zu verbinden.

Für eine CMOS-kompatible elektrische Verbindung zweier mechanisch verbundener Wafer kommt nur Wolfram in Frage, das in einem CVD-Prozeß (CVD = chemical vapour deposition = chemische Dampfabscheidung) aus der Gasphase ($WF_6$) bei 400 bis 450°C abgeschieden wird. Diese Abscheidung des Wolfram kann erst nach dem mechanischen Verbinden der beiden Wafer erfolgen. Dies bedeutet wiederum, daß für die mechanische Verbindung der Wafer ein Verfahren gefunden werden muß, das eine mechanische Verbindung der Wafer liefert, die Temperaturen bis zu 450° C standhalten kann.

Herkömmliche Klebematerialien sind zur Erzeugung einer Verbindung der oben genannten Art, die Temperaturen bis zu 450°C standhalten kann, nicht geeignet, da dieselben nicht ausreichend temperaturstabil sind. Ferner können konventionelle Klebematerialien nicht in der geforderten Homogenität im Bereich von etwa 1 bis 3 µm Dicke auf die Wafer aufgebracht werden. Die Temperaturanforderung verhindert den Einsatz von organischen Klebern, die Homogenitätsanforderung verhindert den Einsatz von Mineralstoff-gefüllten, anorganischen Klebern beim dauerhaften mechanischen Verbinden zweier Wafer.

In dem Artikel "DIRECT BONDING OF ORGANIC POLYMERIC MATERIALS", SPIERINGS G.A.C.M. u.a., in Philips J.Res. 49 (1995), S. 139- 149, sind Verbindungsverfahren, beispielsweise zum Verbinden einer Siliziumschicht mit einer Polyimidschicht bekannt, bei denen eine zunächst hydrophobe Polyimidschicht durch eine Oberflächenbehandlung hydrophil gemacht wird, um nachfolgend mit einem Siliziumwafer verbunden zu werden.

Die DE-A-4404931 offenbart Verfahren und Vorrichtungen zum Direktverbinden zweier Körper. Gemäß den beschriebenen Verfahren und Vorrichtungen wird ein reaktives Gasplasma, beispielsweise Sauerstoff und Wasserstoff, verwendet, um Hydroxidgruppen auf zumindest einer Oberfläche von zwei zu verbindenden Körpern zu bilden, wobei in der DE-A-4404931 als Verbindungskörper beispielsweise Polyimid, $SiO_2$ oder Silizium genannt sind.

In Den Besten C. u.a., "Polymer Bonding of Micro-Machined Silicon Structures", Proceedings of the Workshop on Micro Electro Mechanical Systems '92, Travemünde, 4.-7. Februar 1992 (Nr. Workshop 5, 4.Februar 1992, Benecke W., Petzold H.-C., Seiten 104 - 109, XP000344134), sind unterschiedliche Arten zum Verbinden von Siliziumscheiben beschrieben. Als eine Möglichkeit wird dabei die direkte Verbindung von Silizium zu Silizium beschrieben, die auf einer chemischen Reaktion zwischen OH-Gruppen, die auf der Oberfläche von $SiO_2$ vorliegen, beschrieben. Solche Verbindungsverfahren werden bei 200°C bis 300°C durchgeführt. Als eine weitere Verbindungsart ist in der obigen Schrift ein indirektes Bonden beschrieben, bei dem eine Zwischenschicht aus Natrium-haltigem Glas oder Boron-Glas verwendet wird. Ferner ist die Verwendung einer Zwischenschicht aus Metall zur Durchführung eines eutektischen Bondens beschrieben. Die genannte Schrift offenbart ferner ein Verfahren zum indirekten Verbinden von zwei Siliziumscheiben, bei dem als Verbindungsschichten ein negatives Photoresist, ein Polyimid oder ein Epoxid verwendet wird.

Ausgehend von dem genannten Stand der Technik liegt der vorliegenden Erfindung die Aufgabe zugrunde, ein Verfahren zum dauerhaften Verbinden zweier Siliziumscheiben zu schaffen, wobei die Verbindungsstelle Temperaturen bis zu 500°C standhalten kann und eine geforderte Homogenität aufweist.

Diese Aufgabe wird durch Verfahren zum Verbinden einer ersten und einer zweiten Siliziumscheibe gemäß den Ansprüchen 1 und 4 gelöst.

Die vorliegende Erfindung schafft ein Verfahren zum dauerhaften Verbinden von Siliziumscheiben unter Verwendung einer Polyimidschicht, die vor dem Verbindungsvorgang einer gesonderten Oberflächenmodifikation unterzogen wird. Eine derartige Polyimidschicht ermöglicht ein Waferbondverfahren (Waferbonden = atomares Verbinden von Festkörpern), das bei Bondtemperaturen unter 450°C eine stabile und insbesondere blasenfreie Waferverbindung ermöglicht. Die Verbindungsstelle zweier Wafer, die mittels einer oberflächenmodifizierten Polyimidschicht verbunden sind, weist gegenüber der Schnittstelle einer herkömmlichen Polyimidverbindung zweier Wafer eine stark erhöhte Zugfestigkeit auf.

Gemäß einem ersten Ausführungsbeispiel der vorliegenden Erfindung wird zuerst eine erste Siliziumscheibe auf einer Hauptoberfläche derselben mit einer Polyimidschicht versehen. Nachfolgend wird eine Plasma-induzierte Reaktion zwischen der Polyimidschicht und Wasser bewirkt, um zu erreichen, daß die Oberfläche des Polyimids hydrophil wird. Ferner wird eine Hauptoberfläche einer zweiten Siliziumscheibe, die mit der ersten Siliziumscheibe verbunden werden soll, und Chlor ebenfalls eine Plasma-induzierte Reaktion bewirkt, um dadurch zu erreichen, daß die Hauptoberfläche der zweiten Siliziumscheibe hydrophil wird. Die mit der ersten Siliziumscheibe zu verbindende Hauptoberfläche der zweiten Siliziumscheibe wird im Anschluß mit hydrolisiertem Triethoxysilylpropanamin behandelt. Nachfolgend werden die erste und die zweite Siliziumscheibe unter Zufuhr von Wärme für eine bestimmte Zeitdauer aneinandergefügt, wodurch die Hauptoberflächen derselben verbunden werden.

Gemäß einem weiteren Ausführungsbeispiel wird auf der Hauptoberfläche der zweiten Siliziumscheibe, die mit der ersten Siliziumscheibe verbunden werden soll, eine $SiO_2$-Schicht gebildet. Diese $SiO_2$-Schicht wird mit hydro-lisiertem Triethoxysilylpropanamin behandelt. Die behandelte $SiO_2$-Schicht wird dann entweder direkt mit der Oberflächen-modifizierten Polyimidschicht verbunden oder vor der Verbindung einer Plasma-induzierten Reaktion mit Chlor unterworfen.

Weiterbildungen der vorliegenden Erfindung sind in den abhängigen Ansprüchen dargelegt.

Bevorzugte Ausführungsbeispiele der vorliegenden Erfindung werden nachfolgend teilweise bezugnehmend auf die beiliegenden Zeichnungen näher erläutert. Es zeigen:

Fig. 1    schematisch einen Aufbau zum Durchführen eines Zugversuchs für zwei verbundene Wafer; und

Fig. 2    ein "Abreißspektrum" als Ergebnis des in Fig. 1 schematisch dargestellten Zugversuchs.

Im Folgenden wird die aus dem Englischen entliehene Bezeichnung "Bonden", die die Grundlage des erfindungsgemäßen Verbindungsverfahren bildet, erläutert. Die Bezeichnung "Bonden" soll im Deutschen auf Verbindungen hinweisen, die über eine chemische Reaktion, die zu kovalenten Bindungen führen, zustande kommen. Diese Verbindungstechnik unterscheidet sich klar von Verbindungstechniken, bei denen weitaus schwächere Bindungen mittels eines adhesiven Klebens erzeugt werden. Die durch das "Bonden" zustandegekommene Verbindung weist auch im allgemeinen keinen Klebekörper auf, der durch seine Material-bedingte Temperatur- und Zug-Belastbarkeit die begrenzende Größe darstellen kann, sondern ist ein Vorgang, der unmittelbar an der Oberfläche der zu verbindenden Teile abläuft.

Zur Herstellung dauerhafter Verbindungen muß es daher ein Ziel sein, an Oberflächen zweier zu verbindender Körper gezielt entsprechende funktionelle Gruppen anzukoppeln. Dabei müssen die zu verbindenden Oberflächen mit dem jeweilig komplementären Reaktionspartner belegt werden. Bei der technischen Realisierung zur Verbindung zweier Wafer auf dem Gebiet der Mikroelektronik muß dabei darauf geachtet werden, daß die notwendigen Prozeßschritte zur Modifizierung der zu verbindenden Oberflächen kompatibel mit der IC-Technologie sind. Ferner sollte vorteilhafterweise bereits vorhandenes Equipment für die Bearbeitung verwendet werden können. Idealerweise sollten die Modifizierungsprozesse ohne Einschränkung auf alle vorhandenen Schichtoberflächen angewendet werden können.

Das erfindungsgemäße Verfahren zur dauerhaften Verbindung von anorganischen Wafern basiert auf einem in der Literatur bekannten Ansatz zum Niedertemperaturbonden, nämlich der Kondensationsreaktion, die in Formel (1) dargestellt ist, von Si-OH-Gruppen miteinander unter der Abspaltung von Wasser.

$$2 \text{ Si-OH} \longrightarrow \text{Si-O-Si} + H_2O \qquad (1)$$

Auch die eigentliche Vernetzungsreaktion, mit der die Polymermatrix des Polyimids aufgebaut wird, ist eine mögliche Reaktion, die zum Verbinden des Polyimid mit anderen Oberflächen genutzt werden kann. Ein Schema dieser Vernetzungsreaktion ist in Formel (2) angegeben. Auch diese Reaktion stellt eine Kondensationsreaktion dar, in diesem Fall allerdings zwischen OH- und Amin-Gruppen:

$$R^1\text{-NH}_2 + R^2\text{-COOH} \longrightarrow R^1\text{-NH-CO-}R^2 + H_2O \qquad (2)$$

Hierbei können die mit R bezeichneten Teile unterschiedliche Oberflächen darstellen, wobei $R^1$ beispielsweise eine Siliziumoberfläche und $R^2$ beispielsweise eine Polyimidoberfläche ist. Beide mittels der Formeln (1) und (2) dargestellten Reaktionen laufen thermisch induziert unterhalb von 400°C ab.

Bei dem erfindungsgemäßen Verfahren wird zur Verbindung zweier Wafer Polyimid nur in seiner voll ausgehärteten Form eingesetzt. Dazu wird das Polyimid nach dem Aufbringen desselben, beispielsweise durch ein Aufschleudern (Spin-on-Verfahren), auf die Waferoberfläche ausgeheizt (400°C). Danach sind sämtliche funktionellen Gruppen des Polyimids, die für einen Klebeprozeß genutzt werden könnten, nicht mehr vorhanden. Die Oberfläche der ausgeheizten Polyimidschicht muß daher einer Oberflächenkonditionierung unterzogen werden. Dies hat entweder eine Reaktivierung der Polyimidoberfläche durch ein Aufbrechen der oberflächennahen Polyimidringe oder zumindest die Bildung von OH-Gruppen zur Folge. In beiden Fällen kann dann eine der oben genannten Kondensationsreaktionen zur Verbindung der Polyimidoberfläche mit einer Siliziumoberfläche genutzt werden.

Als mögliche Behandlungsmethoden der zu verbindenden Oberflächen wurden Plasma-induzierte Reaktionen zwischen den zu verbindenden Oberflächen mit Wasser, Sauerstoff und Chlor als reaktive Medien untersucht. Der Nachweis der geänderten Oberflächenbelegung, d.h. die Folge der Plasma-induzierten Reaktionen, kann mittels der Messung des Kontaktwinkels von Wasser vor und nach den entsprechenden Behandlungen geführt werden. Tabelle 1 zeigt Meßergebnisse, die den Kontaktwinkel von Wasser in Abhängigkeit von der Oberflächenbehandlung von Polyimid, $SiO_2$ und Silizium darstellen. Wie der Tabelle zu entnehmen ist, läßt bei Polyimid Wasser als Medium in dem Plasma die Oberfläche am besten hydrophil werden, während bei Silizium und $SiO_2$ Chlorgas am besten geeignet ist, um die Oberflächen zu hydrophilisieren. Die Tabelle zeigt ferner, daß $SiO_2$ bereits ohne eine Plasma-induzierte Reaktion einen geringen Kontaktwinkel aufweist, so daß $SiO_2$ ohne eine Oberflächenbehandlung desselben zur Verbindung mit einer modifizierten Polyimidoberfläche verwendet werden kann.

Tabelle 1:

| Kontaktwinkel in Abhängigkeit von der Oberflächenbehandlung | | | | | |
|---|---|---|---|---|---|
| | Kontaktwinkel $\alpha$ | | | | |
| Material | Orginal-Oberfläche | $H_2O$-Plasma Plas.Pot. | $O_2/H_2O$-Plasma 100VDC + $H_2O$-Dip | $Cl_2$-Plasma 30VDC + $H_2O$-Dip | HMDS 15 min, T=21°C |
| Polyimid | 63°-71° | 0°-31° | | | |
| PE-$SiO_2$ | 32° | 47° | 30° | < 5° | 70° |
| Silizium HF-Dip | 63° | | | < 5° | |

Der Ausdruck PE-$SiO_2$ in der Tabelle steht für plasmaunterstützt abgeschiedenes Siliziumdioxid (PE = plasma enhanced). Der Ausdrücke $H_2O$-Dip bzw. HF-Dip stehen für das Spülen in de-ionisiertem Wasser bzw. Flußsäure. HMDS ist Hexamethyldisilazan. Der Ausdruck Plas.Pot. steht für Plasmapotential und der Ausdruck VDC steht für V Gleichspannung.

Die hydrophilisierten Oberflächen von Silizium und $SiO_2$ werden mit einem Haftvermittler für Polyimid, d.h. hydrolisiertem Triethoxysilylpropanamin, behandelt, um die Amingruppe entsprechend der Reaktion der Formel (2) zur Verfügung zu stellen. Dadurch kann gemäß einem alternativen erfindungsgemäßen Verfahren eine dauerhafte Verbindung zwischen zwei Wafern erreicht werden.

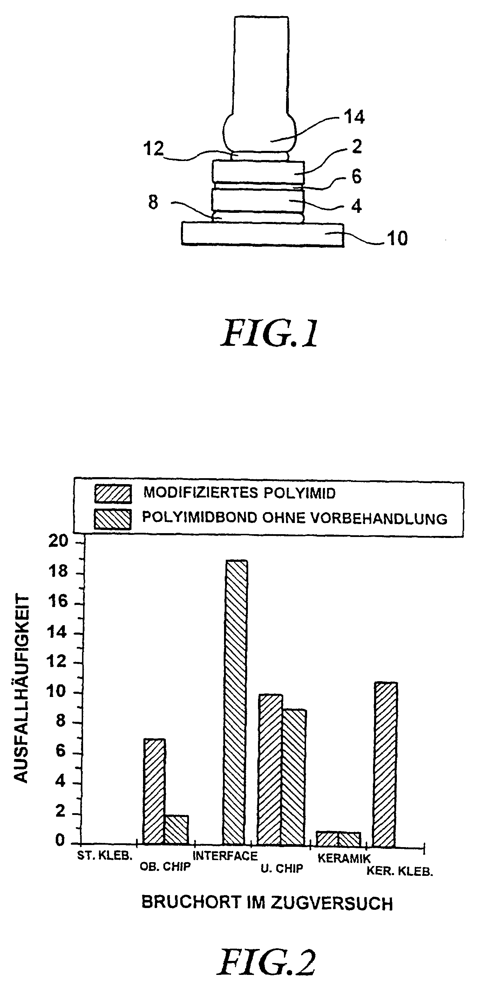

Ein weiterer objektiver Nachweis der Oberflächenmodifikation besteht in der Messung der Festigkeit der entstandenen Bindung. Ein Versuchsaufbau zum Messen der Festigkeit ist in Fig. 1 dargestellt. Ein oberer Wafer 2 und ein unterer Wafer 4 wurden dabei mittels des erfindungsgemäßen Verfahrens durch eine Polyimidschicht 6 verbunden. Der untere Wafer 4 ist mittels eines Keramikklebers 8 auf einer Keramikplatte 10 befestigt. Der obere Wafer 2 ist mittels eines Stempelklebers 12 an einem Stempel 14 befestigt. Die Keramikplatte 10 und der Stempel 14, der beispielsweise aus Aluminium besteht, sind Teil einer Abreißvorrichtung, des sogenannten Sebastian-Viktor-Testers. Um einen objektiven Nachweis der Oberflächenmodifikation zu führen, wurden unterschiedlich modifizierte, mit Polyimid beschichtete Wafer gebondet, in Chips der Größe 5 mm x 5 mm gesägt und anschließend einem Zerreißversuch, bei dem die Haftfestigkeit der Bondstellen ermittelt wurde, unterworfen. Der durchgeführte Versuch ermöglicht Aussagen über die Haftfestigkeit der Bondfuge, falls der Abriß an der Verbindungsgrenzfläche des gebondeten Chips stattfindet, über den unteren Grenzwert für die Haftfestigkeit, falls der Bruch im Chip-Aufbau, explizit nicht an der Grenzfläche des gebondeten Chips, erfolgt, und über die Verteilung der Haftfestigkeit über die Waferoberfläche, wodurch eine Kontrolle der Homogenität der Vorbehandlung und des Bondvorgangs möglich ist.

In Fig. 2 ist das Abreißspektrum eines gebondeten Wafers ohne und mit einer Oberflächenmodifikation der zu verbindenden Oberflächen gegenübergestellt. Dabei sind als mögliche Bruchstellen der Stempelkleber, der obere Chip, die Bondfuge, der untere Chip, die Keramik und der Keramikkleber angegeben. Wie der Fig. 2 zu entnehmen ist, erhöht die Vorbehandlung die Bondfestigkeit soweit, daß der Abriß ausschließlich an den Befestigungen der Wafer an dem Stempel und der Keramikplatte oder dem Silizium selbst, nicht jedoch an der Bondfuge stattfindet. Im Gegensatz dazu findet bei einem Polyimidbonden ohne einer Vorbehandlung der Polyimidfläche der Großteil der Ausfälle direkt an der Bondfuge statt. Die Vorbehandlung gemäß der vorliegenden Erfindung liefert somit eine Bondfuge, die in der Zugfestigkeit die mechanische Festigkeit des Siliziumchips oder auch der Trägerkeramik der verwendeten Abreißvorrichtung übertrifft.

Eine optimale Bondfuge ergibt sich bei der Verbindung von Polyimid und Silizium, wenn das Polyimid einer Plasma-induzierten Reaktion mit $H_2O$ und das Silizium einer Plasma-induzierten Reaktion mit $Cl_2$ unterworfen wird. Soll ein mit einer Polyimidschicht versehener Wafer mit einem mit einer thermischen Oxidschicht versehenen Wafer verbunden werden, kann die Verbindung entweder ohne eine Vorbehandlung des thermischen Oxids oder nach dem Modifizieren des thermischen Oxids durch eine Plasma-induzierte Reaktion mit $Cl_2$ durchgeführt werden.

Nachfolgend wird ein spezielles bevorzugtes Ausführungsbeispiel des erfindungsgemäßen Verfahrens zur dauerhaften Verbindung von Siliziumscheiben mittels einer Polyimidschicht beschrieben.

Zuerst werden die zwei zu verbindenden Siliziumwafer bereitgestellt. Danach wird Polyimid in einer flüssigen Vorstufe (Precursor) auf eine Hauptoberfläche eines der zu verbindenden Wafer aufgeschleudert. Nachfolgend wird ein Temperschritt oberhalb von 200°C durchgeführt, um eine Imidisierungsreaktion zu bewirken. Bei dieser Imidisierungsreaktion spaltet jedes Polyimid-Precursormolekül zwei $H_2O$-Moleküle ab. Nachfolgend wird eine Zyklisierung bis 400°C in einem Stickstoff-gespülten Ofen durchgeführt, um das kondensierte Wasser vollständig aus dem Polyimidfilm auszutreiben. Eine derart vollzyklisierte Polyimidschicht ist temperaturstabil bis über 500°C. Die oben beschriebene Kondensationsreaktion verhindert die Möglichkeit, den weichen, nicht vollständig imidisierten Polyimidfilm als konventionelle Klebefuge zu verwenden.

Infolge der oben beschriebenen Behandlung des einen zu verbindenden Wafers liegt nun ein Wafer mit einer Polyimidschicht und ein Wafer ohne Polyimidschicht vor. Der mit der Polyimidschicht versehene Wafer wird zusammen mit Wasser in einen HF-Entladungsraum eingebracht. Nachfolgend wird das HF-Plasma gezündet. Die Parameter für die Plasma-induzierte Reaktion lauten wie folgt: Druckbereich: $0,1\text{-}1,0\cdot10^2$ Pascal; $H_2O$-Fluß: 0,1-1,0 ml/min; HF-Leistung: 100-500 W bei einer 8"-Fläche; der Ausdruck 8"-Fläche bezieht sich auf die Fläche, auf die das Plasma wirkt, d.h. eine runde Fläche mit einem Durchmesser von 20,32 cm (8"). Damit ergibt sich eine Leistungsdichte zwischen etwa 0,3 $W/cm^2$ und etwa 1,6 $W/cm^2$. Dabei kann beispielsweise ein runder Wafer mit einem Durchmesser von 15 cm verwendet werden.

Der Wafer befindet sich während des Bewirkens der Plasma-induzierten Reaktion jeweils auf der Einkoppelelektrode des HF-Entladungsraums, d.h. im sogenannten RIE-Mode (RIE = reactive ion etching = reaktives Ionenätzen). Nach dem Prozeßende wird der Wafer bei dem bevorzugten Ausführungsbeispiel des erfindungsgemäßen Verfahrens aus dem HF-Entladungsraum entnommen und sofort in entionisiertem Wasser (DI-Wasser) gespült, zum einen um eventuelle Partikel zu entfernen und zum anderen um verbliebene, nicht abgesättigte Bindungen mit OH-Gruppen abzusättigen. Damit ist die Vorbehandlung des mit der Polyimidschicht versehenen Wafers abgeschlossen.

Im Folgenden wird die Vorbehandlung des nicht mit der Polyimidschicht versehenen Wafers beschrieben. Der Wafer wird zusammen mit Chlor ($Cl_2$) in einen HF-Entladungsraum eingebracht. Nachfolgend wird das HF-Plasma gezündet. Die Plasma-induzierte Reaktion findet unter folgenden Parametern statt: Druckbereich: $0,1\text{-}1,0\cdot10^2$ Pascal; $Cl_2$-Fluß: 10-200 ml/min (10-200 sccm; sccm = Kubikzentimeter pro Minute bei Standardbedingungen, d.h. Raumtemperatur und Normaldruck); HF-Leistung: 100-500 W (8"-Fläche; ==> Leistungsdichte zwischen 0,3 $W/cm^2$ und 1,6 $W/cm^2$). Auch hierbei befindet sich der Wafer auf der Einkoppelelektrode des HF-Entladungsraums im sogenannten RIE-Mode. Nach Abschluß der Plasma-induzierten Reaktion wird der Wafer aus dem HF-Entladungsraum entnommen und bei dem beschriebenen Ausführungsbeispiel sofort in entionisiertem Wasser gespült. Ferner wird bei dem bevorzugten Ausführungsbeispiel die mit Chlor modifizierte Seite mit hydrolisiertem Triethoxysilylpropanamin behandelt. Nach dieser Behandlung ist die Vorbereitung des zweiten Wafers abgeschlossen.

Als letzter Verfahrensschritt werden die beiden Wafer nachfolgend aufeinandergelegt, um dieselben zu verbinden. Dazu werden die aufeinandergelegten Wafer beispielsweise innerhalb eines Zeitraums von 30 Minuten bis 4 Stunden auf 400°C aufgeheizt. Dadurch wird eine dauerhafte Bondfuge zwischen den beiden Wafern erhalten.

Alternativ zu dem oben beschriebenen Verfahren kann der mit der Polyimidschicht versehene Wafer auch mit einem Wafer, der eine $SiO_2$-Schicht als zu verbindende Schicht aufweist, verbunden werden. In diesem Fall kann die $SiO_2$-Schicht auf die gleiche Art und Weise behandelt werden, die oben hinsichtlich des zweiten Siliziumwafers beschrieben wurde. Es ist jedoch auch möglich, die $SiO_2$-Schicht direkt mit der modifizierten Polyimidschicht zu verbinden.

Die vorliegende Erfindung schafft somit ein Verfahren zum Verbinden einer ersten und einer zweiten Siliziumscheibe mittels einer Polyimidschicht, wobei die Verbindungsstelle sogar die mechanische Festigkeit der Siliziumscheiben übertrifft. Die erfindungsgemäße Oberflächenbehandlung verbessert in allen Fällen die Benetzung mit dem Vorteil, daß die Partikelbelastung zusätzlicher Prozeßschritte auf die vorhandene Entionisierungswasserbecken-Spezifikation reduziert werden kann. Ferner paßt die Oberflächenpolarität bei dem erfindungsgemäßen Verfahren zu dem Haftvermittler für Polyimid.

**Patentansprüche**

1.  Verfahren zum Verbinden einer ersten und einer zweiten Siliziumscheibe mit folgenden Schritten:

    a1) Versehen der ersten Siliziumscheibe mit einer voll ausgehärteten Polyimidschicht auf einer Hauptoberfläche derselben;

    b1) Bewirken einer Plasma-induzierten Reaktion zwischen der Polyimidschicht und Wasser, um zu bewirken, daß eine mit der zweiten Siliziumscheibe zu verbindende Oberfläche der Polyimidschicht hydrophil wird;

    c1) Bewirken einer Plasma-induzierten Reaktion zwischen einer Hauptoberfläche der zweiten Siliziumscheibe, die mit der Polyimidschicht verbunden werden soll, und Chlor, um zu bewirken, daß die Hauptoberfläche der zweiten Siliziumscheibe hydrophil wird;

    d1) Behandeln der mit der Polyimidschicht zu verbindenden Hauptoberfläche der zweiten Siliziumscheibe mit hydrolisiertem Triethoxysilylpropanamin, um Amin-Gruppen auf der Hauptoberfläche der zweiten Siliziumscheibe zu erzeugen; und

    e1) Verbinden der ersten und der zweiten Siliziumscheibe durch das Aneinanderfügen der zu verbindenden Hauptoberfläche der zweiten Siliziumscheibe und der zu verbindenden Hauptoberfläche der Polyimidschicht unter Zufuhr von Wärme für eine bestimmte Zeitdauer.

2.  Verfahren gemäß Anspruch 1, das nach dem Schritt c1) ferner den Schritt des Spülens der zweiten Siliziumscheibe mit entionisiertem Wasser aufweist.

3.  Verfahren gemäß einem der Ansprüche 1 bis 3, bei dem der Schritt c1) bei einem Druck von 0,1-1,0·10$^2$ Pascal, einem Cl$_2$-Fluß von 10-200 ml/min und einer HF-Leistungsdichte im Bereich zwischen 0,3 W/cm$^2$ und 1,6 W/cm$^2$ in einem HF-Entladungsraum durchgeführt wird.

4.  Verfahren zum Verbinden einer ersten und einer zweiten Siliziumscheibe mit folgenden Schritten:

    a4) Versehen der ersten Siliziumscheibe mit einer voll ausgehärteten Polyimidschicht auf einer Hauptoberfläche derselben;

    b4) Bewirken einer Plasma-induzierten Reaktion zwischen der Polyimidschicht und Wasser, um zu bewirken, daß eine mit der zweiten Siliziumscheibe zu verbindende Oberfläche der Polyimidschicht hydrophil wird;

    c4) Bilden einer SiO$_2$-Schicht auf einer Hauptoberfläche der zweiten Siliziumscheibe;

    d4) Behandeln der SiO$_2$-Schicht mit hydrolisiertem Triethoxysilylpropanamin, um Amin-Gruppen auf einer mit der Polyimidschicht zu verbindenden Hauptoberfläche der SiO$_2$-Schicht zu erzeugen; und

    e4) Verbinden der ersten und der zweiten Siliziumscheibe durch das Aneinanderfügen der zu verbindenden Hauptoberfläche der SiO$_2$-Schicht und der zu verbindenden Hauptoberfläche der Polyimidschicht unter Zufuhr von Wärme für eine bestimmte Zeitdauer.

5.  Verfahren gemäß Anspruch 4, das nach dem Schritt c4) den Schritt c4') des Bewirkens einer Plasma-induzierten Reaktion zwischen der SiO$_2$-Schicht und Chlor aufweist.

6.  Verfahren gemäß Anspruch 5, das nach dem Schritt c4') ferner den Schritt des Spülens der SiO$_2$-Schicht mit entionisiertem Wasser aufweist.

7.  Verfahren gemäß Anspruch 5 oder 6, bei dem der Schritt c4') bei einem Druck von 0,1-1,0·10$^2$ Pascal, einem Cl$_2$-Fluß von 10-200 ml/min und einer HF-Leistungsdichte im Bereich zwischen 0,3 W/cm$^2$ und 1,6 W/cm$^2$ in einem HF-Entladungsraum durchgeführt wird.

8.  Verfahren gemäß einem der Ansprüche 1 bis 7, bei dem der Schritt b1) bzw. b4) bei einem Druck von 0,1 - 1,0·10$^2$ Pascal, einem H$_2$O-Fluß von 0,1-1 ml/min und einer HF-Leistungsdichte im Bereich zwischen 0,3 W/cm$^2$ und 1,6

W/cm$^2$ in einem HF-Entladungsraum durchgeführt wird.

9. Verfahren gemäß einem der Ansprüche 1 bis 8, bei dem die jeweiligen Oberflächen für einen Zeitraum von 30 Minuten bis 4 Stunden bei einer Temperatur von 350°C bis 450°C aneinandergefügt werden.

10. Verfahren gemäß einem der Ansprüche 1 bis 9, das nach dem Schritt b1) bzw. b4) ferner den Schritt des Spülens der Polyimidschicht mit entionisiertem Wasser aufweist.

11. Verfahren gemäß einem der Ansprüche 1 bis 10, bei dem das Polyimid im Schritt a1) bzw. a4) in einer flüssigen Vorstufe auf die Hauptoberfläche der ersten Siliziumscheibe aufgeschleudert und nachfolgend einer Temperaturbehandlung unterzogen wird.

12. Verfahren gemäß einem der Ansprüche 1 bis 11, bei dem sich die zu behandelnde Siliziumscheibe während des Bewirkens der Plasma-induzierten Reaktion jeweils auf der Einkoppelelektrode des HF-Entladungsraums befindet.

## Claims

1. A method of connecting a first and a second silicon wafer, comprising the following steps:

   a1) providing the first silicon wafer with a fully cured polyimide layer on a main surface thereof;

   b1) causing a plasma-induced reaction to take place between the polyimide layer and water so as to make a surface of the polyimide layer, which is to be connected to the second silicon wafer, hydrophile;

   c1) causing a plasma-induced reaction to take place between a main surface of the second silicon wafer, which is to be connected to the polyimide layer, and chlorine so as to make the main surface of the second silicon wafer hydrophile;

   d1) treating the main surface of the second silicon wafer, which is to be connected to the polyimide layer, with hydrolyzed triethoxysilylpropanamine so as to produce amino groups on the main surface of the second silicon wafer; and

   e1) connecting the first and second silicon wafers by joining together the main surface of the second silicon wafer to be connected and the main surface of the polyimide layer to be connected while heat is being supplied for a specific period of time.

2. A method according to claim 1, comprising after the step c1) the additional step of rinsing the second silicon wafer with deionized water.

3. A method according to one of the claims 1 to 3, wherein step c1) is carried out at a pressure of 0.1-1.0·10$^2$ Pascal, a Cl$_2$ flow of 10-200 ml/min and an HF power density in the range of 0.3 W/cm$^2$ to 1.6 W/cm$^2$ in an HF discharge chamber.

4. A method of connecting a first and a second silicon wafer, comprising the following steps:

   a4) providing the first silicon wafer with a fully cured polyimide layer on a main surface thereof;

   b4) causing a plasma-induced reaction to take place between the polyimide layer and water, so as to make a surface of the polyimide layer, which is to be connected to the second silicon wafer, hydrophile;

   c4) forming an SiO$_2$ layer on the main surface of the second silicon wafer;

   d4) treating the SiO$_2$ layer with hydrolyzed triethoxysilylpropanamine so as to produce amino groups on a main surface of the SiO$_2$ layer to be connected to the polyimide layer; and

   e4) connecting the first and second silicon wafers by joining together the main surface of the SiO2 layer to be connected and the main surface of the polyimide layer to be connected while heat is being supplied for a specific period of time.

5. A method according to claim 4, comprising after the step c4) the additional step c4') of causing a plasma-induced reaction between the $SiO_2$ layer and chlorine.

6. A method according to claim 5, comprising after the step c4') the additional step of rinsing the $SiO_2$ layer with deionized water.

7. A method according to claim 5 or 6, wherein step c4') is carried out at a pressure of $0.1$-$1.0 \cdot 10^2$ Pascal, a $Cl_2$ flow of 10-200 ml/min and an HF power density in the range of 0.3 W/cm$^2$ to 1.6 W/cm$^2$ in an HF discharge chamber.

8. A method according to one of the claims 1 to 7, wherein step b1) and b4), respectively, are carried out at a pressure of $0.1$-$1.0$-$10^2$ Pascal, a $H_2O$ flow of 0.1-1 ml/min and an HF power density in the range of 0.3 W/cm$^2$ to 1.6 W/cm$^2$ in an HF discharge chamber.

9. A method according to one of the claims 1 to 8, wherein the respective surfaces are joined together at a temperature of $350°$ to $450°$ for a period of time from 30 minutes to 4 hours.

10. A method according to one of the claims 1 to 9, comprising after steps b1) and b4), respectively, the additional step of rinsing the polyimide layer with deionized water.

11. A method according to one of the claims 1 to 10, wherein, in steps a1) and a4), respectively, the polyimide in the form of a liquid precursor is applied by spinning to the main surface of the first silicon wafer and is then subjected to a temperature treatment.

12. A method according to one of the claims 1 to 11, wherein the silicon wafer to be treated is located on the respective coupling-in electrode of the HF discharge chamber while being acted upon by the plasma-induced reaction.

**Revendications**

1. Procédé pour assembler une première et une seconde plaquette de silicium, aux étapes suivantes consistant à :

   a1) pourvoir la première plaquette de silicium d'une couche de polyimide complètement durcie, sur une surface principale de celle-ci ;
   b1) provoquer une réaction induite au plasma entre la couche de polyimide et de l'eau, pour obtenir qu'une surface de la couche de polyimide à assembler avec la seconde plaquette de silicium devienne hydrophile ;
   c1) provoquer une réaction induite au plasma entre une surface principale de la seconde plaquette de silicium qui doit être assemblée avec la couche de polyimide et du chlore, pour obtenir que la surface principale de la seconde plaquette de silicium devienne hydrophile ;
   d1) traiter la surface principale de la seconde plaquette de silicium à assembler avec la couche de polyimide, pour générer des groupes amine sur la surface principale de la seconde plaquette de silicium ; et
   e1) assembler la première et la seconde plaquette de silicium en joignant la surface principale à assembler de la seconde plaquette de silicium et la surface principale à assembler de la couche de polyimide avec amenée de chaleur pendant un laps de temps déterminé.

2. Procédé selon la revendication 1, présentant, après l'étape c1), par ailleurs, l'étape consistant à rincer la seconde plaquette de silicium avec de l'eau déionisée.

3. Procédé selon l'une des revendications 1 à 3, dans lequel l'étape c1) est réalisée dans une chambre de décharge HF à une pression de $0,1$ à $1,0 \cdot 10^2$ Pascals, un écoulement de $Cl_2$ de 10 à 200 ml/min et une densité de puissance HF de l'ordre de 0,3 W/cm$^2$ à 1,6 W/cm$^2$.

4. Procédé pour assembler une première et une seconde plaquette de silicium, aux étapes suivantes consistant à :

   a4) pourvoir la première plaquette de silicium d'une couche de polyimide complètement durcie, sur une surface principale de celle-ci ;
   b4) provoquer une réaction induite au plasma entre la couche de polyimide et de l'eau, pour obtenir qu'une surface de la couche de polyimide à assembler avec la seconde plaquette de silicium devienne hydrophile ;

c4) former une couche de $SiO_2$ sur une surface principale de la seconde plaquette de silicium ;

d4) traiter la couche de $SiO_2$ avec de la triéthoxysilylpropanamine, pour générer des groupes amine sur une surface principale de la couche de $SiO_2$ à assembler avec la couche de polyimide ; et

e1) assembler la première et la seconde plaquette de silicium en joignant la surface principale à assembler de la couche de $SiO_2$ et la surface principale à assembler de la couche de polyimide avec amenée de chaleur pendant un laps de temps déterminé.

5. Procédé selon la revendication 4, présentant, après l'étape c4), l'étape c4') consistant à provoquer une réaction induite au plasma entre la couche de $SiO_2$ et du chlore.

6. Procédé selon la revendication 5, présentant, après l'étape c4'), par ailleurs l'étape consistant à rincer la couche de $SiO_2$ avec de l'eau déionisée.

7. Procédé selon la revendication 5 ou 6, dans lequel l'étape c4') est réalisée dans une chambre de déchargement HF à une pression de 0,1 à $1,0 \cdot 10^2$ Pascals, un écoulement de $Cl_2$ de 10 à 200 ml/min et une densité de puissance HF de l'ordre de 0,3 W/cm$^2$ à 1,6 W/cm$^2$.

8. Procédé selon l'une des revendications 1 à 7, dans lequel l'étape b1 ou b4) est réalisée dans une chambre de déchargement HF à une pression de 0,1 à $1,0 \cdot 10^2$ Pascals, un écoulement de $H_2O$ de 0,1 à 1 ml/min et une densité de puissance HF de l'ordre de 0,3 W/cm$^2$ à 1,6 W/cm$^2$.

9. Procédé selon l'une des revendications 1 à 8, dans lequel les surfaces respectives sont assemblées l'une à l'autre pendant un laps de temps de 30 minutes à 4 heures, à une température de 350°C à 450°C.

10. Procédé selon l'une des revendications 1 à 9, présentant, après l'étape b1) ou b4), par ailleurs, l'étape consistant à rincer la couche de polyimide avec de l'eau déionisée.

11. Procédé selon l'une des revendications 1 à 10, dans lequel la couche de polyimide est, à l'étape a1) ou a4), en une préétape liquide, centrifugée sur la surface principale de la première plaquette de silicium et, ensuite, soumise à un traitement thermique.

12. Procédé selon l'une des revendications 1 à 11, dans lequel la plaquette de silicium à traiter se trouve, pendant la provocation de la réaction induite au plasma, chaque fois sur l'électrode de couplage de la chambre de décharge HF.

FIG.1

FIG.2